# EUROPÄISCHE PATENTSCHRIFT

(11) **EP 0 906 008 B1**
(45) Veröffentlichungstag und Bekanntmachung des Hinweises auf die Patenterteilung: **15.12.2004**
(21) Anmeldenummer: 98116762.0
(22) Anmeldetag: 04.09.1998
(51) Int. Cl.: H05K 7/14, H05K 3/32, H05K 9/00, H01R 12/04, H01R 12/32

(54) **Kunststoffgehäuse zur Aufnahme einer elektrischen Leiterplatte**
Plastic housing for an electric board
Boîtier plastique pour loger un circuit electrique

(30) Priorität: 26.09.1997 DE 19742458
(43) Veröffentlichungstag der Anmeldung: 31.03.1999
(73) Patentinhaber: Conti Temic Microelectronic GmbH, 90411 Nürnberg (DE)
(72) Erfinder: Baur, Richard, 85276 Pfaffenhofen (DE); Fendt, Günter, 86529 Schrobenhausen (DE)

(56) Entgegenhaltungen:
- DE-A- 4 001 554
- DE-A- 4 330 977
- DE-U- 29 709 904
- GB-A- 2 269 946
- US-A- 5 286 920
- US-A- 5 644 474

## Beschreibung

Die Erfindung betrifft ein Kunststoffgehäuse zur Aufnahme einer elektrischen Leiterplatte gemäß dem Oberbegriff des Patentanspruchs 1.

Elektronische Baugruppen werden insbesondere in der Automobilindustrie zunehmend mit Kunststoffgehäusen ausgeführt, da diese neben der relativ einfachen und kostengünstigen Herstellung insbesondere erheblich leichter sind, wodurch wiederum der Spritverbrauch sinkt. Zur Befestigung der Kunststoffgehäuse an einem metallischen Trägerkörper weist das Kunststoffgehäuse im allgemeinen einen Montageflansch mit einer Öffnung auf. Da jedoch das Kunststoffgehäuse an der Öffnung durch Montagekräfte, beispielsweise beim Verschrauben oder vernieten, recht leicht beschädigt werden kann, wird ein metallisches Einlegeteil mit lochverstärkender Wirkung eingesetzt, wie dies beispielsweise der DE 90 07 621 U1 (Hohlniet 4 der Figur 1) zu entnehmen ist.

Kunststoffgehäuse weisen jedoch den Nachteil auf, daß mit Ihnen keine elektrische Verbindung zu einem metallischen Trägerkörper möglich ist, wie dies zur Massekontaktierung insbesondere in der KFZ-Industrie eingesetzt wird. Eine reine kraftschlüssige Verbindung, beispielsweise durch Verschrauben der Leiterplatte am metallischen Trägergehäuse ist für die Sicherheitsanforderung in der KFZ-Industrie ungeeignet, da die Leiterplatte nicht vollständig vom Kunststoffgehäuse umschlossen werden kann und außerdem durch eine derartige kraftschlüssige Verbindung der elektrische Kontakt nicht über die Produktlebensdauer hinweg garantiert werden kann. Insbesondere zeigt die Leiterplatte die Eigenschaft, sich im Bereich der kraftschlüssigen Verbindung über die Zeit hinweg leicht zu verformen und letztlich den für den elektrischen Kontakt erforderlichen breiten Berührungsbereich zu verlieren. Durch das Kunststoffgehäuse hindurchgeführte und darin eingeschweißte Kabel, wie sie bspw. aus der DE 43 30 977 C2 entnommen werden können, sind äußerst bruchanfällig.

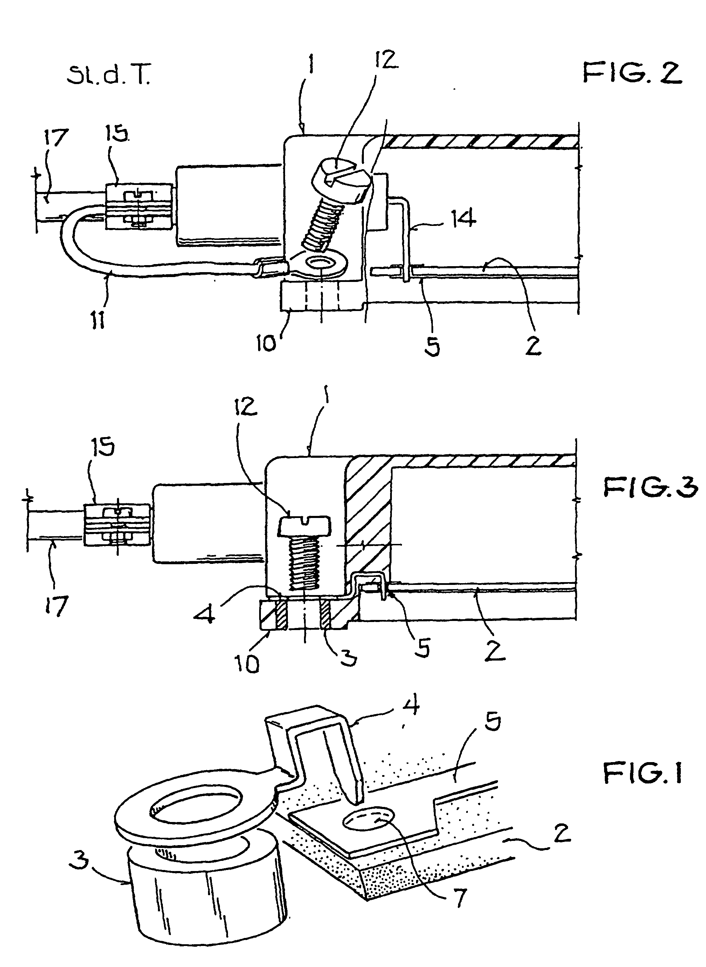

Aus diesem Grunde werden derzeitig die elektrischen Masseanschlüsse zusammen mit den anderen Anschlüssen für die Leiterplatte durch eine Steckerkonstruktion im Kunststoffgehäuse geführt und von dort mittels einer Kabelklemme oder dergleichen bei der Montage am Anschraubpunkt mit dem metallischen Trägerkörper und somit mit Masse verbunden. Ein solches Kunststoffgehäuse mit einer über einen Steckerbereich geführten Massekontaktierung gemäß dem Stand der Technik zeigt Figur 2. Im Gehäuse 1 befindet sich die Leiterplatte 2, welche eine elektrische Verbindung 14 zu dem Steckerbereich 15 aufweist. Im Steckerbereich 15 wird ein nicht näher dargestellter Massepin mit einer Leitung 11 außerhalb des Kunststoffgehäuses 1 verbunden und zum Montageflansch 10 sowie dem mechanischen Verbindungsmittel 12 (als Schraube dargestellt) geleitet. Der Aufwand für einen derartigen separaten Massepin im Steckerbereich, insbesondere die Teilekosten, und für die Montage einschließlich der Leitung 11 außerhalb des Gehäuses 1 ist jedoch erheblich. Eine dazu analoge Lösung ist aus der DE 297 09 904 U1 zu entnehmen. Zusätzliche Kontaktfedern zur Erdung sind aus der DE 91 14 287 U1 zu entnehmen.

Die Aufgabe der Erfindung ist es daher ein Kunststoffgehäuse aufzuzeigen, mit welchem auf einfache Art und Weise eine elektrische Verbindung zwischen Leiterplatte und metallischen Trägerkörper realisiert werden kann.

Diese Aufgabe wurde durch die Merkmale des Patentanspruchs 1 gelöst.

Grundgedanke ist es, den bisher zur rein mechanischen Stabilisierung des Montageflansches eingesetzten metallischen Einlegeteil als elektrischen Leiter zu verwenden und diesen mit einem elektrischen Anschluß an der Leiterplatte elektrisch zu verbinden. Die wirtschaftlichen Vorteile durch die Einsparung im Steckerbereich können dabei von wettbewerbsentscheidender Bedeutung sein. Die notwendige elektrische Verbindung zwischen dem metallischen Einlegeteil und dem elektrischen Anschluß an der Leiterplatte können dabei gemäß Patentanspruch 2 besonders vorteilhaft dadurch realisiert werden, daß eine elektrische Leitung, beispielsweise ein entsprechend der Form des Kunststoffgehäuses gebogenes Metall- oder Drahtelement, innerhalb des Kunststoffgehäusematerials vom Leiterplattenanschluß zum metallischen Einlegeteil führt. Ein derartiges elektrisches Verbindungsteil wird beispielsweise bei der Herstellung des Kunststoffgehäuses direkt mit der Kunststoffmasse verspritzt. Es kann auch mit dem metallischen Einlegeteil verbunden oder aus diesem ausgeformt sein.

Vorteilhaft ist ebenfalls die zweite Variante der Schaffung der elektrischen Verbindung zum Leiterplattenanschluß über eine elektrisch leitende Schicht an der Oberfläche des Kunststoffgehäuses, vorzugsweise an der inneren Seite. Die Abscheidung einer entsprechenden Metallisierungsbahn ist bekanntermaßen recht einfach möglich.

Grundsätzlich kann die elektrische Verbindung zwischen dem metallischen Einlegeteil und der Leiterplatte auch über ein metallisches Teil im Kunststoffgehäuse, bspw. eine Abschirmplatte oder ein metallisches Teil des an sich aus Kunststoff bestehenden Gehäuses realisiert werden.

Eine bevorzugte Weiterbildung der Erfindung zeigt Patentanspruch 5, bei dem die elektrische Leitung im Inneren des Kunststoffgehäuses an der Oberfläche zu einem metallischen Einpreßstift führt, der bei der Montage einerseits in einer zumindest teilweise metallisierten Öffnung im Kunststoffgehäuse und andererseits in einer im elektrischen Leiterplattenanschluß befindliche Öffnung eingepreßt und beidseitig arretiert wird.

Die Erfindung wird nachfolgend anhand von Ausführungsbeispielen und Figuren näher erläutert.

Kurze Beschreibung der Figuren:
- Figur 1: elektrisch leitendes Verbindungsteil, welches zwischen dem metallischen Einlegeteil im Montageflansch und der Anschlußzone der Leiterplatte eine elektrische Verbindung schafft und im Kunststoffgehäuse eingespritzt oder beigelegt wird
- Figur 2: Kunststoffgehäuse gemäß dem Stand der Technik mit einer Leitung außerhalb des Gehäuses zum Montageflansch
- Figur 3: Kunststoffgehäuse mit dem elektrisch leitenden Verbindungsteil zwischen dem metallischen Einlegeteil im Montageflansch und der Anschlußzone der Leiterplatte
- Figur 4: Einpreßstift zwischen dem Verbindungsteil und der Anschlußzone der Leiterplatte
- Figur 5: Schnitt durch ein montiertes Kunststoffgehäuse, bei dem zwischen dem Verbindungsteil und der Anschlußzone der Leiterplatte ein Einpreßstift vorgesehen ist

Figur 1 zeigt im Detail ein elektrisch leitendes Verbindungsteil 4, welches zwischen dem metallischen Einlegeteil 3 im Montageflansch 10 und der Anschlußzone 5 der Leiterplatte 2 eine elektrische Verbindung schafft. Das metallischen Einlegeteil 3 sowie die Anschlußzone 5 der Leiterplatte 2 sind in Figur 1 skizzenhaft angedeutet. Das elektrische Verbindungsteil 4 ist in diesem Ausführungsbeispiel aus einem Metallblech geformt, kann aber auch durch eine entsprechend gebogene Drahtkonstruktion realisiert werden. Es ist auch denkbar, das elektrisch leitende Verbindungsteil 4 fest mit dem metallischen Einlegeteil 3 zu verbinden oder aus einem Stück zu fertigen. Das elektrisch leitende Verbindungsteil 4 ist jeweils der Kunststoffgehäuseform und der Lage der Anschlußzone 5 sowie des metallischen Einlegeteils 3 im Montageflansch 10 entsprechend geformt. Das elektrisch leitende Verbindungsteil 4 wird im Kunststoffgehäusematerial eingespritzt oder beigelegt, wie in Figur 3 dargestellt. Das elektrisch leitende Verbindungsteil 4 ist in die Anschlußzone 5 der Leiterplatte 2 eingepreßt oder eingelötet, wobei bei einer Preßverbindung evtl. auf eine Verlötung verzichtet werden kann, sofern die Anschlußzone 5 auch auf der Innenseite der Öffnung 7 entsprechend metallisiert ist. Figur 2 zeigt den Stand der Technik.

Figur 3 zeigt ein Kunststoffgehäuse 1 mit dem elektrisch leitenden Verbindungsteil 4 zwischen dem metallischen Einlegeteil 3 im Montageflansch 10 und der Anschlußzone 5 der Leiterplatte 2. Der Massekontakt erfolgt somit nicht über den Steckerbereich 15 mit der Anschlußleitung 17, sondern direkt von der Anschlußzone 5 der Leiterplatte 2 über das elektrisch leitende Verbindungsteil 4 und das metallische Einlegeteil 3 hin zu einem in Fig. 3 nicht näher gezeigten metallischen Trägerkörper, der seinerseits mit der elektrischen Masse verbunden ist. Dem Verbindungsmittel 12 kann dabei jedoch auch eine elektrische Verbindungsfunktion zukommen, falls es aus einem elektrisch leitenden Material ist.

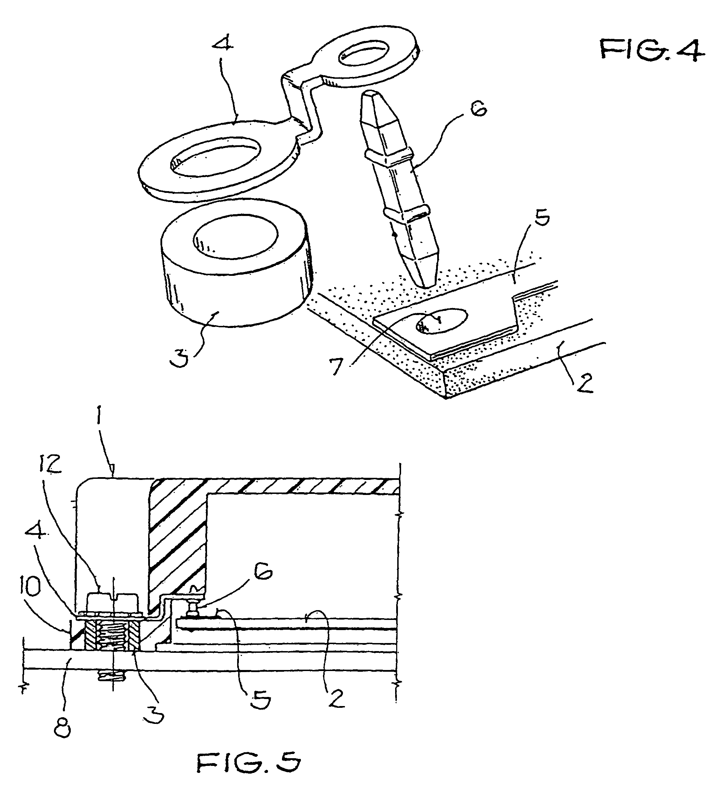

Figur 4 stellt einen Einpreßstift 6 zwischen dem elektrisch leitenden Verbindungsteil 6 und der Anschlußzone 5 der Leiterplatte 2 dar, wobei letzeres sowie das metallische Einlegeteil 3 wieder skizzenhaft angedeutet sind. Die Öffnung 7 in der Anschlußzone 5 der Leiterplatte 2 ist dabei so bemessen, daß es zu einem Einpressen und einer starren Arretierung des Einpreßstifts 6 bei der Montage kommt.

Figur 5 zeigt analog zu Figur 3 einen Schnitt durch ein montiertes Kunststoffgehäuse 1, bei dem in diesem Ausführungsbeispiel zwischen dem Verbindungsteil 4 und der Anschlußzone 5 der Leiterplatte 2 ein Einpreßstift 6 gemäß Figur 4 vorgesehen ist. In Fig. 5 ist die mechanische Verbindung des mechanischen Verbindungsmittels (Schraube) 12 mit dem metallischen Trägerkörper 8 dargestellt. Gerade die Ausgestaltung mit dem zweiseitigen Einpreßstift 6 ist auch zur elektrischen Verbindung zu einem metallischen Teil hin geeignet, welches Bestandteil des Gehäuses, beispielsweise eine Abschirmplatte ist. Auch für Gehäuse mit Metallteilen oder vollmetallischen Gehäusen kann sie eingesetzt werden und dabei auch auf ein anderes metallischen Verbindungsteil verzichtet werden, wenn eine direkte Verbindung zum metallischen Einlegeteil 3 besteht.

## Patentansprüche

1. Kunststoffgehäuse (1) zur Aufnahme einer elektrischen Leiterplatte (2), welches in einem Montageflansch (10) eine Öffnung mit einem metallischen Einlegeteil (3) aufweist, wobei das Kunststoffgehäuse (1) am Montageflansch (10) über ein mechanisches Verbindungsmittel (12) an einem metallischen Trägerkörper (8) befestigt wird, **dadurch gekennzeichnet, daß** ein elektrischer Leiterplattenanschluß (5) über elektrische Verbindungsmittel (4,6) mit dem metallischen Einlegeteil (3) und über dieses wiederum mit dem metallischen Trägerkörper (8) elektrisch verbunden ist.

2. Kunststoffgehäuse gemäß Anspruch 1, **dadurch gekennzeichnet, daß** die elektrische Verbindung zum Leiterplattenanschluß (5) über ein separates elektrisch leitendes Verbindungsteil (4) innerhalb des Kunststoffgehäusematerials erfolgt.

3. Kunststoffgehäuse gemäß Anspruch 1, **dadurch gekennzeichnet, daß** die elektrische Verbindung zum Leiterplattenanschluß (5) über eine elektrisch leitende Schicht an der Oberfläche des Kunststoffgehäusematerials erfolgt.

4. Kunststoffgehäuse gemäß Anspruch 1, **dadurch gekennzeichnet, daß** die elektrische Verbindung zum Leiterplattenanschluß (5) über ein im Kunststoffgehäuse befindliches metallisches Teil erfolgt.

5. Kunststoffgehäuse gemäß einem der vorangehenden Ansprüche, **dadurch gekennzeichnet, daß** die elektrische Leitung innerhalb des Kunststoffgehäusematerials zu einem metallischen Einpreßstift (6) führt, der bei der Montage durch eine im elektrischen Leiterplattenanschluß (5) befindliche Öffnung (7) eingepreßt und somit arretiert sowie elektrisch verbunden ist.

## Claims

1. Plastics housing (1) for accommodating an electrical printed circuit board (2), which housing comprises in an assembly flange (10) an opening with a metallic insert (3), wherein the plastics housing (1) is fastened at the assembly flange (10) by way of a mechanical connecting means (12) to a metallic carrier body (8), **characterised in that** an electrical printed circuit board terminal (5) is electrically connected by way of electrical connecting means (4, 6) to the metallic insert (3) and by way of this in turn to the metallic carrier body (8).

2. Plastics housing according to Claim 1, **characterised in that** the electrical connection to the printed circuit board terminal (5) is effected by way of a separate electrically conductive connecting part (4) inside the plastics housing material.

3. Plastics housing according to Claim 1, **characterised in that** the electrical connection to the printed circuit board terminal (5) is effected by way of an electrically conductive layer at the surface of the plastics housing material.

4. Plastics housing according to Claim 1, **characterised in that** the electrical connection to the printed circuit board terminal (5) is effected by way of a metallic part located in the plastics housing.

5. Plastics housing according to any one of the preceding Claims, **characterised in that** the electrical conductor inside the plastics housing material leads to a metallic press-in pin (6) which, upon assembly, is pressed through an opening (7) located in the electrical printed circuit board terminal (5) and thus secured and electrically connected.

## Revendications

1. Boîtier plastique (1) destiné à recevoir un module électrique (2), lequel comporte un orifice avec un insert (3) métallique ménagé dans une bride de montage (10), le boîtier plastique (1) étant fixé avec la bride de montage (10) contre un corps de support (8) métallique par l'intermédiaire d'un moyen d'assemblage (12) mécanique, **caractérisé en ce qu'**une connexion électrique (5) du module est reliée électriquement par des moyens de liaison électrique (4, 6) avec l'insert (3) métallique et par l'intermédiaire de celui-ci avec le corps de support (8) métallique.

2. Boîtier plastique selon la revendication 1, **caractérisé en ce que** la liaison électrique vers la connexion (5) du module est établie à l'intérieur du matériau du boîtier plastique par l'intermédiaire d'un élément de jonction électroconducteur (4) séparé.

3. Boîtier plastique selon la revendication 1, **caractérisé en ce que** la liaison électrique vers la connexion (5) du module est établie sur la surface du matériau du boîtier plastique par l'intermédiaire d'une couche électroconductrice.

4. Boîtier plastique selon la revendication 1, **caractérisé en ce que** la liaison électrique vers la connexion (5) du module est établie par l'intermédiaire d'une pièce métallique disposée dans le boîtier plastique.

5. Boîtier plastique selon l'une quelconque des revendications précédentes, **caractérisé en ce que** la ligne électrique à l'intérieur du matériau du boîtier plastique est guidée vers une pointe à enficher (6) métallique qui, en cours de montage, est enfoncée à travers un orifice (7) ménagé dans la connexion électrique (5) du module et, de ce fait, est bloquée et reliée électriquement.
